# EUROPEAN PATENT APPLICATION

(11) **EP 1 434 255 A2**
(43) Date of publication of application: **30.06.2004**
(21) Application number: 03029553.9
(22) Date of filing: 22.12.2003
(51) Int. Cl.: H01L 21/00

(54) **Apparatus for processing substrate by process solution**

(30) Priority: 25.12.2002 JP 2002375097
(71) Applicant: CANON KABUSHIKI KAISHA, Tokyo (JP)
(72) Inventor: Yamagata, Kenji, Tokyo (JP); Sakaguchi, Kiyofumi, Tokyo (JP); Yanagita, Kazutaka, Tokyo (JP); Sugai, Takashi, Tokyo (JP); Takanashi, Kazuhito, Tokyo (JP)
(74) Representative: Leson, Thomas Johannes Alois, Dipl.-Ing.

(57) **Abstract**

Even when the substrate size increases, the substrate is processed (etched) uniformly. An ultrasonic oscillator (103) is arranged under an etching container (101). A substrate (120) is horizontally arranged in the etching container (101). Accordingly, the substrate (120) is arranged while making a surface face the ultrasonic oscillator (103). The substrate (120) is etched while being rotated by a rotating mechanism (130).

## Description

### FIELD OF THE INVENTION

The present invention relates to the field of substrate processing by a process solution, for example, wet etching.

### BACKGROUND OF THE INVENTION

As an industrial application of porous semiconductors, a technique for manufacturing SOI (Silicon On Insulator or Semiconductor On Insulator) by using porous silicon is known. As an application of this technique, a wafer direct bonding technique is disclosed in Japanese Patent Laid-Open No. 5-21338 in which a silicon epitaxial layer is grown on a porous silicon layer on a substrate and bonded to an amorphous substrate or single-crystal silicon substrate via an oxide film.

One of important techniques for the manufacture of SOI substrates is a selective etching technique for porous silicon. Porous silicon is generally formed by porosifying a surface of a single-crystal silicon substrate. For this reason, it is difficult to obtain etching selectivity between the porous silicon and a portion under it (non-porous silicon).

Selective etching methods for porous silicon are disclosed in Japanese Patent Laid-Open Nos. 10-223585, 10-229066, 10-242102, 10-242103, 6-342784, 9-92803, 11-204494, 11-204495, 2000-133632, and 2000-133558.

The inventions described in the above patent references are useful in terms of selective etching techniques for porous semiconductors and excellent in mass productivity. In the prior arts, however, as the substrate size increases, the etching distribution may deteriorate or the process time may increase.

### SUMMARY OF THE INVENTION

It is an object of the present invention to uniformly process substrates even when they have a large size, in terms of application to selective etching, prevent any deterioration in etching selectivity distribution even when the substrates have a large size, and accordingly realize a satisfactory etching distribution.

An apparatus according to the present invention is a processing apparatus which processes a substrate by a process solution. The apparatus comprises a process container which stores the process solution, a holding mechanism which holds the substrate in the process container, an oscillation source which is arranged at a predetermined position in a direction perpendicular to a surface of the substrate held by the holding mechanism to supply an oscillation to the substrate, and a structure configured to rotate the substrate held by the holding mechanism.

According to a preferred embodiment of the present invention, the structure can be configured to transmit a rotating force to the substrate by a solid member. In this case, the structure can be configured to rotate the substrate by, e.g., rotating the holding mechanism.

The structure may be configured to rotate the substrate by forming a flow of the process solution. In this case, the structure can be configured to rotate the substrate by forming one of a rotational flow and a vortex flow of the process solution in the process container.

Alternatively, the structure can have a supply portion which supplies the process solution into the process container to form a flow of the process solution in the process container and be configured to rotate the substrate by the flow of the process solution.

According to another preferred embodiment of the present invention, the processing apparatus of the present invention preferably further comprises a discharge portion which discharges the process solution to the surface of the substrate to remove bubbles that can be generated in processing the substrate. The discharge portion can be configured to discharge the process solution to a local region in the surface of the substrate. The processing apparatus of the present invention preferably further comprises a driving mechanism which moves the discharge portion during processing of the substrate. The driving mechanism can be configured to be able to reciprocally move the discharge portion to sequentially inject the process solution discharged from the discharge portion to an entire surface of the substrate.

According to still another preferred embodiment of the present invention, the processing apparatus of the present invention preferably further comprises a mechanism which deaerates the process solution.

According to still another preferred embodiment of the present invention, the processing apparatus of the present invention preferably further comprises a chamber to form a low-pressure environment in a space including at least a portion where the process solution in the process container is exposed. Alternatively, the processing apparatus of the present invention preferably further comprises a chamber to accommodate the process container and form a low-pressure environment around the process container.

An apparatus according to the second aspect of the present invention is also a processing apparatus which processes a substrate by a process solution. The apparatus comprises a process container which stores the process solution, and a structure which rotates the substrate by forming a flow of the process solution in the process container.

An apparatus according to the third aspect of the present invention is also a processing apparatus which processes a substrate by a process solution. The apparatus comprises a process container which stores the process solution, and a discharge portion which discharges the process solution to a surface of the substrate in the process container to remove bubbles that can be generated in processing the substrate.

An apparatus according to the fourth aspect of the present invention is also a processing apparatus which processes a substrate by a process solution. The apparatus comprises a process container which stores the process solution, and a chamber to form a low-pressure environment in a space including at least a portion where the process solution in the process container is exposed.

The processing apparatuses according to the first to fourth aspects can be constituted or used as an etching apparatus, as will be described below as the embodiments of the present invention.

The present invention is also useful as a processing method of processing a substrate by a process solution.

A processing method of the present invention comprises an arrangement step of arranging the substrate in a process container which stores the process solution, and a process step of processing the substrate by the process solution while rotating the substrate, wherein in the arrangement step, the substrate is arranged while making a surface of the substrate face an oscillation source which supplies an oscillation to the substrate, and in the process step, the oscillation source is operated to supply the oscillation to the substrate.

According to a preferred embodiment of the present invention, in the process step, the substrate can be rotated by transmitting a rotating force to the substrate by using a solid member. In the process step, the substrate can also be rotated by forming a flow of the process solution. For example, the substrate can be rotated by forming one of a rotational flow and a vortex flow of the process solution in the process container.

According to another preferred embodiment of the present invention, in the process step, the process solution is preferably discharged to the surface of the substrate to remove bubbles that can be generated in processing the substrate. In the process step, the process solution is preferably discharged to a local region in the surface of the substrate. In the process step, the substrate is preferably processed while changing the region of the substrate to which the process solution should locally be supplied. In the process step, the process solution is preferably sequentially injected to an entire surface of the substrate while changing the region of the substrate to which the process solution should locally be supplied.

According to still another preferred embodiment of the present invention, at least in the process step of the processing method of the present invention, the process solution is preferably deaerated.

According to still another preferred embodiment of the present invention, the process step is preferably executed while forming a low-pressure environment in a space including a portion where the process solution in the process container is exposed.

A method according to the second aspect of the present invention is also a processing method of processing a substrate by a process solution. The method comprises an arrangement step of arranging the substrate in a process container which stores the process solution, and a process step of processing the substrate by the process solution while rotating the substrate, wherein in the process step, the substrate is rotated by forming a flow of the process solution.

A method according to the third aspect of the present invention is also a processing method of processing a substrate by a process solution. The method comprises an arrangement step of arranging the substrate in a process container which stores the process solution, and a process step of processing the substrate by the process solution while rotating the substrate, wherein in the process step, the process solution is discharged to the surface of the substrate to remove bubbles that can be generated in processing the substrate.

A method according to the fourth aspect of the present invention is also a processing method of processing a substrate by a process solution. The method comprises an arrangement step of arranging the substrate in a process container which stores the process solution, and a process step of processing the substrate by the process solution while rotating the substrate, wherein the process step is executed while forming a low-pressure environment in a space including a portion where the process solution in the process container is exposed.

The processing methods according to the first to fourth aspects can comprise a step of etching the substrate, as will be described below as the embodiments of the present invention. Preferably, the substrate has a porous region and a non-porous region, and in the etching step, the porous region of the substrate is selectively etched.

A manufacturing method according to the present invention is a method of manufacturing a semiconductor substrate. The method comprises steps of bonding a second substrate to a side of a non-porous semiconductor layer of a first substrate to prepare a bonded substrate stack, the first substrate having the non-porous semiconductor substrate on a porous layer, processing or fabricating the bonded substrate stack to prepare an intermediate substrate in which the non-porous semiconductor layer is present on the second substrate, and the porous layer at least partially remains on the non-porous semiconductor layer, and selectively etching the remaining porous layer in the intermediate substrate by the above etching step.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a view showing the schematic structure of an etching apparatus (processing apparatus) according to a preferred embodiment of the present invention;
Fig. 2 is a view showing the schematic structure of an improved example of the etching apparatus (processing apparatus);
Figs. 3A and 3B are views showing an example of a rotating mechanism which rotates a substrate by the flow of a fluid;
Fig. 4 is a view showing another example of the rotating mechanism which rotates a substrate by a solid member;
Fig. 5 is a view for explaining a mechanism for selective etching of a porous silicon portion;
Fig. 6 is a view showing the schematic structure of a conventional etching apparatus;
Fig. 7 is a view for explaining nonuniformity of etching;
Fig. 8 is a view showing the arrangement relationship of a substrate and an ultrasonic oscillator which are suitable for uniforming etching;
Fig. 9 is a view for explaining a local etching accelerating method;
Figs. 10A to 10C are views for explaining steps in manufacturing an SOI substrate;
Figs. 11A to 11C are views for explaining an application example of a structure having a porous region and a non-porous region; and
Fig. 12 is a view showing an example of an anodizing apparatus.

### DETAILED DESCRIPTION OF THE PREFERRED EMBODIMENTS

A mechanism for selectively etching only a porous silicon portion in a substrate having a non-porous silicon portion and a porous silicon portion, and typically, a substrate having non-porous silicon under porous silicon will be described.

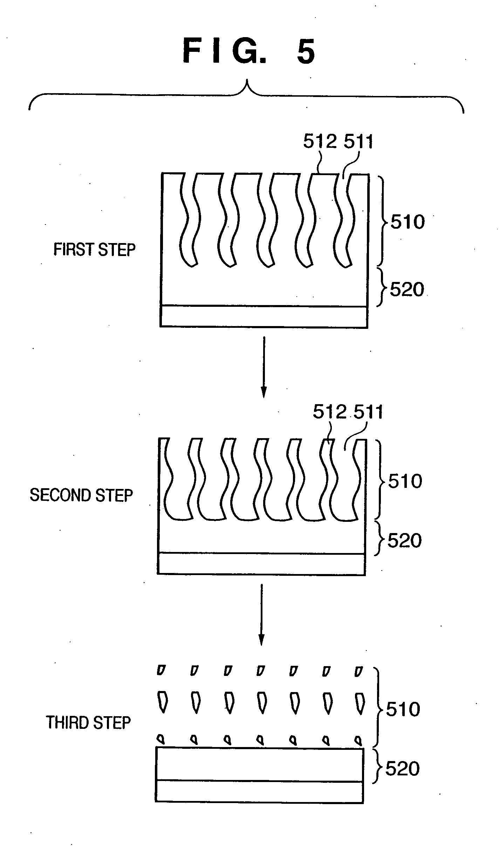

A case wherein a porous silicon layer 510 is formed on a surface, and a non-porous silicon layer 520 to be exposed by selective etching is present under the porous silicon layer 510, as shown in Fig. 5, will be described.

In the first step, an etchant soaks into pores 511 in the porous silicon layer 510 due to a capillary phenomenon. In the second step, the etchant that has soaked etches a wall 512 in the porous silicon layer 510. At this time, the non-porous silicon layer 520 exposed to the etchant is also isotropically etched. However, when the etching rate is set to be very low (e.g., 0.05 to 0.1 nm/min), hardly any non-porous silicon layer 520 is etched. On the other hand, the wall 512 in the porous layer 510 is also etched at a similar etching rate. Typically, the average size (average pore diameter) of the pores 511 in the porous silicon layer 510 before etching is about 5 to 7 nm. The thickness of the wall 512 is 10 to 20 nm. Hence, the wall 512 can be etched within a practical time even at the above etching rate.

In the third step of selective etching, the wall 512 that becomes thinner in etching collapses and disappears. The selective etching is thus completed. If the thickness of the wall 512 before etching is 10 to 20 nm, the wall 512 is expected to collapse when it is etched by 5 to 10 nm, i.e., 1/2 the original thickness. It is known in fact that the porous structure portion (wall) collapses at an earlier stage by an external physical action such as the etchant flow or ultrasonic oscillation.

Hence, the porous silicon layer 510 is actually removed by etching of several nm. The single-crystal silicon layer 520 under the porous silicon layer 510 is etched by only several nm and can remain almost perfect.

In the selective etching of the porous silicon layer, it is important to cause the collapse of the porous structure in the third step almost uniformly and simultaneously on the entire surface of the substrate. If the porous layer partially remains, etching must continuously be performed until that portion is removed. In this case, the non-porous silicon layer at a portion where the porous layer is removed before is undesirably etched although the etching rate is very low. This leads to a nonuniform film thickness distribution in the non-porous silicon layer.

An etching apparatus which can suitably be used to cause the collapse of the porous structure almost uniformly on the entire surface of the substrate in a short time will be described below. When the process solution is changed, the etching apparatus to be described below can also be used as a processing apparatus for another processing. For example, when a cleaning solution is used as the process solution, the apparatus to be described below can be used as a cleaning apparatus.

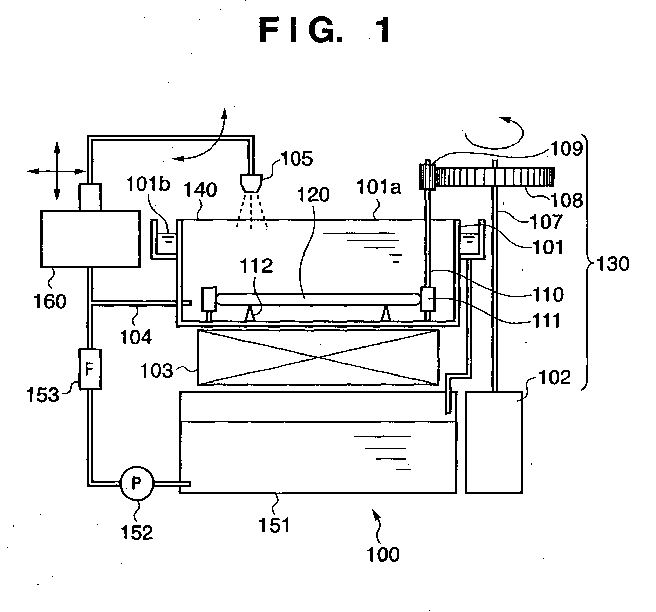

Fig. 1 is a view showing the schematic structure of an etching apparatus according to a preferred embodiment of the present invention. In an etching apparatus 100 shown in Fig. 1, an ultrasonic oscillator (oscillation source) 103 is arranged at the bottom of an etching container (process container) 101 which stores an etchant (process solution) 140. A substrate to be processed is supported horizontally. According to this arrangement, ultrasonic oscillation is almost uniformly supplied to the entire surface of a substrate (e.g., a wafer) 120 having a porous layer or porous region on its surface. Hence, the collapse of the porous layer can almost uniformly and simultaneously occur in the plane. The substrate to be processed is placed in the etching container 101 while making one surface (typically the lower surface) face the ultrasonic oscillator 103. In other words, the ultrasonic oscillator 103 is arranged at a predetermined position in a direction perpendicular to the surface of the substrate to be processed.

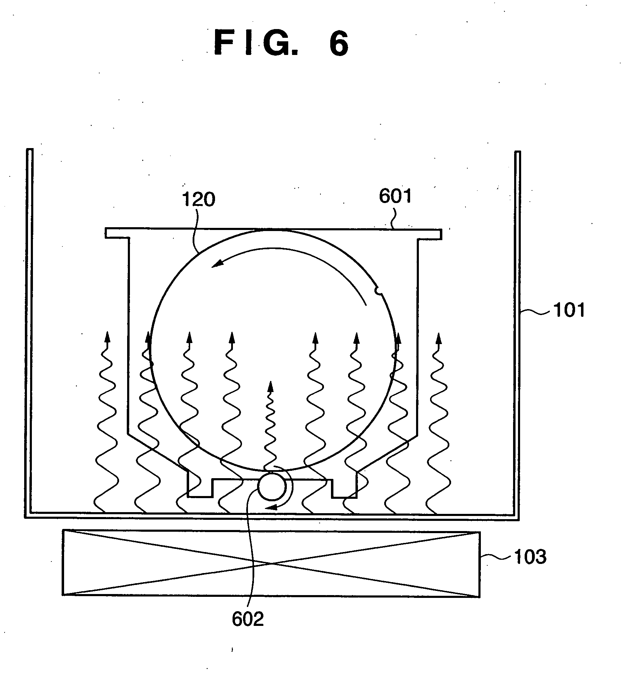

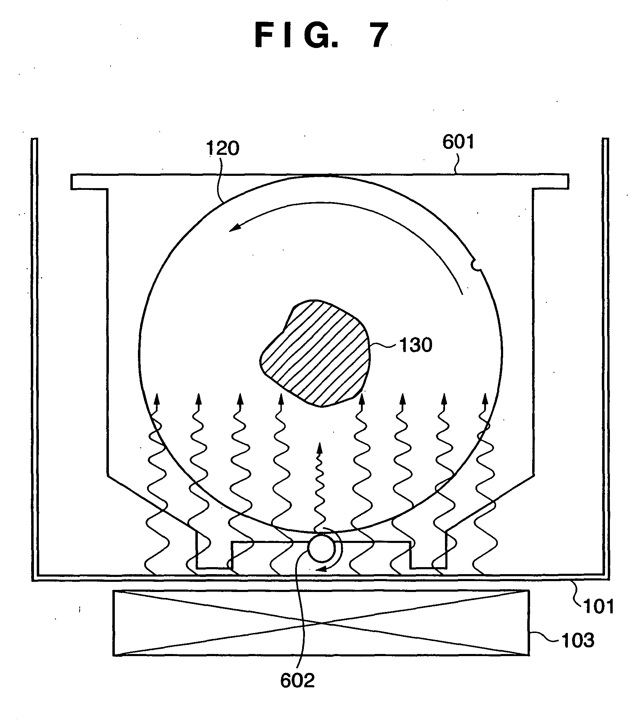

On the other hand, in a conventional apparatus, as shown in Fig. 6, the ultrasonic oscillator 103 is installed under the etching container 101. The substrate 120 is processed while being accommodated in a carrier 601 and having its surfaces set in the vertical direction. In this case, ultrasonic oscillation generated by the ultrasonic oscillator 103 is transmitted from the bottom of the etching container 101 to the substrate 120. The vibration attenuates toward the upper portion of the substrate 120. To cause the ultrasonic wave to uniformly act on the substrate 120, the substrate 120 is rotated by a roller 602. However, as the size of the substrate 120 increases, the uniformity of the ultrasonic effect can hardly be maintained. As shown in Fig. 7, the porous silicon layer readily remains near the center of the substrate.

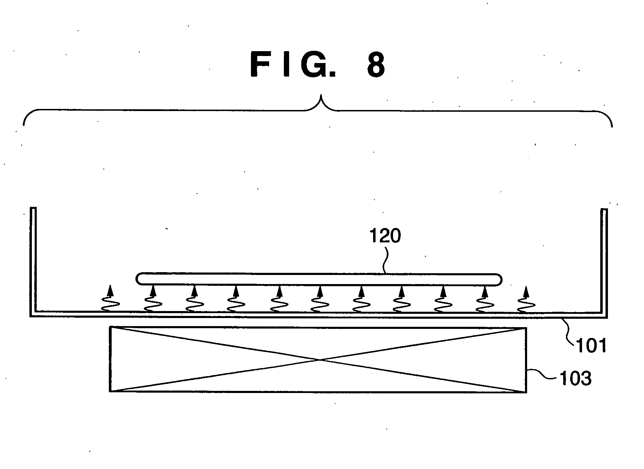

To prevent this, it is preferable to horizontally set the substrate and arrange the ultrasonic oscillator 103 below the substrate (i.e., parallel to the substrate surface), as shown in Fig. 1. That is, the substrate is preferably set while making one surface face the ultrasonic oscillator. According to this arrangement, even when the substrate size increases, the ultrasonic wave can almost uniformly act on the entire surface of the substrate, as shown in Fig. 8. Hence, the porous layer can uniformly collapse on the entire surface of the substrate.

As shown in Fig. 1, the etching container 101 has a main body container 101a and overflow container 101b. The etchant that has overflowed from the main body container 101a is collected by the overflow container 101b. The etchant collected by the overflow container 101b returns to a tank 151. The etchant in the tank 151 is supplied to the main body container 101a of the etching container 101 by a pump 152 through a supply portion (e.g., a nozzle) 104 and a supply portion (e.g., a nozzle) 105. A filter 153 can typically be inserted between the tank 151 and the supply portions 104 and 105.

The substrate 120 to be processed is typically supported from the lower side. The substrate 120 is therefore set in the etching container 101 while making the surface with the porous layer face up.

The etching apparatus 100 shown in Fig. 1 as the preferred embodiment of the present invention also has a mechanism or structure which rotates the substrate 120 during etching to increase the uniformity of the collapse of the porous layer or porous structure. The substrate 120 is preferably rotated by, e.g., a solid member that is brought into contact with the substrate or the flow of a fluid (etchant).

The etching apparatus 100 shown in Fig. 1 has a rotating mechanism 130 which rotates the substrate by a solid member as the mechanism or structure which rotates the substrate. More specifically, the rotating mechanism 130 has a structure which brings a roller 111 into contact with the edge of the substrate 120 to rotate the substrate 120. The roller 111 is connected to the rotating shaft of a motor 102 through a connecting shaft 110, gear 109, gear 108, and connecting shaft 107. The substrate 120 is supported from the lower side by a support member (holding mechanism) 112.

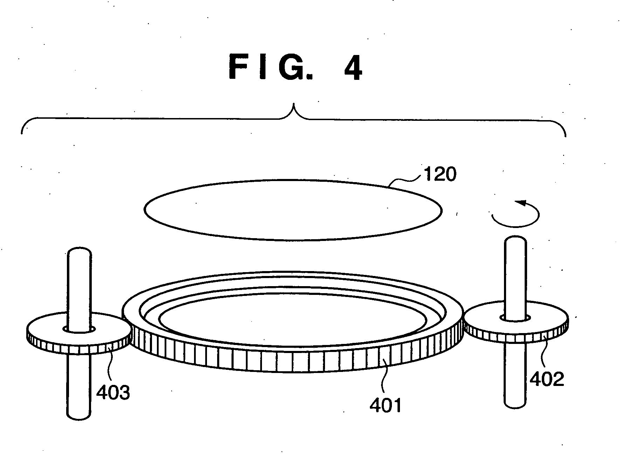

Fig. 4 is a view showing another example of the rotating mechanism which rotates the substrate. The rotating mechanism shown in Fig. 4 can be employed in place of the rotating mechanism 130 shown in Fig. 1. The rotating mechanism shown in Fig. 4 has a ring-shaped substrate holder 401 which holds the substrate 120, and gears 402 and 403 which transmit the rotating force to the substrate holder 401 to rotate the substrate holder 401 (and the substrate). The substrate holder 401 is preferably designed to support the substrate 120 from only the lower side of its edge portion. Accordingly, the ultrasonic wave can efficiently act on the substrate 120. A rotating force is transmitted from a motor (not shown) to the gears 402 and 403.

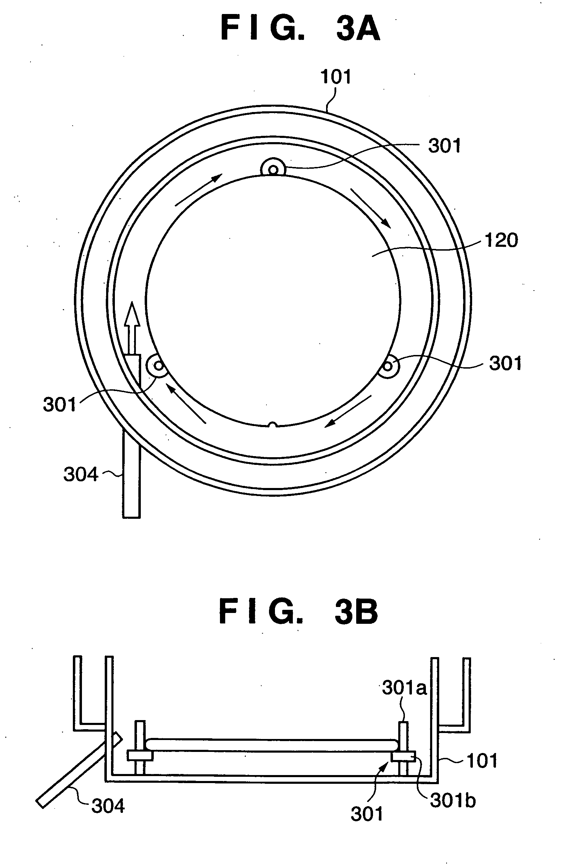

Figs. 3A and 3B are views showing an example of a rotating mechanism which rotates the substrate by the flow of a fluid. The rotating mechanism shown in Figs. 3A and 3B can be employed in place of the rotating mechanism 130 shown in Fig. 1. Fig. 3A is a plan view showing the etching apparatus from the upper side. Fig. 3B is a longitudinal sectional view of the etching apparatus. In the rotating mechanism shown in Figs. 3A and 3B, a supply portion (e.g., a nozzle) 304 (corresponding to the supply portion 104 in Fig. 1) which supplies the etchant into the etching container 101 is arranged to form a vortex flow or rotational flow of the etchant in the etching container 101. In this example, the supply portion 304 has both the function of forming a vortex flow or rotational flow and the function of supplying the etchant into the etching container 101. These functions may be implemented by separate structures (i.e., an etchant supply mechanism and a vortex or rotational flow generation mechanism (e.g., a screw or propeller)).

The horizontal and vertical positions of the substrate 120 in the etching container 101 are regulated by a plurality of (e.g., three) guides 301. Each guide 301 has, e.g., a pin portion (horizontal regulation member) 301a which regulates the horizontal position of the substrate and a ring portion (vertical regulation member) 301b which regulates the vertical position of the substrate. The pin portion 301a and ring portion 301b are preferably designed to minimize the resistance in rotating the substrate 120.

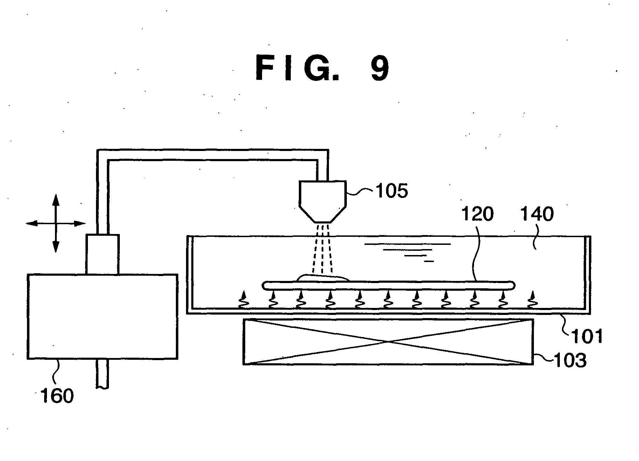

The etching apparatus will be described in more detail with reference to Figs. 1 and 9. The etching apparatus 100 according to the preferred embodiment of the present invention has the etchant supply portion (discharge portion) 105 which discharges the etchant toward the surface to be processed to further increase the uniformity of the collapse of the porous layer. This embodiment assumes that the substrate is set while causing the surface to the processed, i.e., the surface having the porous layer to face up. Hence, the supply portion 105 is arranged above the substrate. The collapse of the porous structure occurs when the etchant that has soaked into the pores etches the wall, as described above. Bubbles are generated by chemical reaction in etching. When the fresh etchant discharged from the supply portion 105 is injected to the porous layer of the substrate 120, the reaction bubbles sticking to the porous layer can efficiently be removed. In addition, the fresh etchant efficiently replaces the etchant (e.g., the etchant in the pores in the porous layer) that has already contributed to the etching reaction so that the etching of the porous layer can be promoted. The supply portion 105 may be designed to inject the etchant either to the entire surface of the substrate 120 or to a localized region of the entire surface of the substrate 120. In the example shown in Figs. 1 and 9, the etchant is supplied to a localized region of the substrate 120. This arrangement can effectively control the etching rate distribution.

The etching apparatus 100 has a moving mechanism 160 which moves the supply portion 105 on the upper side in the horizontal direction and, more preferably, also in the vertical direction. For example, as shown in Fig. 9, if a portion where the porous layer readily remains is steadily generated in the selective etching of the porous layer, the supply portion 105 is positioned by the moving mechanism 160 such that the fresh etchant is preferentially supplied to that portion. Accordingly, the nonuniformity of the etching can be reduced. The moving mechanism 160 is preferably designed to, when a region (coordinates) to which the fresh etchant should preferentially be supplied is set, and the substrate 120 is set at a predetermined position in the etching container 101, automatically move the supply portion 105 to above that region.

The moving mechanism 160 may be designed to change the position of the supply portion 105 as the etching process progresses. For example, the supply portion 105 is reciprocally moved in the radial direction of the substrate by the moving mechanism 160 while the substrate 120 is rotated by the rotating mechanism 130. With this operation, bubbles (reaction bubbles) generated by the etching reaction and sticking to the substrate can efficiently be removed. In addition, the fresh etchant can efficiently replace the etchant that has already contributed to the reaction. Since local etching promotion by the supply portion 105 sequentially acts on the entire surface of the substrate 120, the time necessary for the etching can be shortened. If there exists a region where the porous layer is hard to etch, the movement or moving speed of the supply portion 105 is controlled such that the etching is promoted in that region more than in the remaining regions. Accordingly, the porous layer can be etched uniformly on the entire surface of the substrate.

When an ultrasonic oscillator is attached to or near the supply portion 105, an etchant with ultrasonic oscillation can be supplied from the supply portion 105 to the substrate. With the bubble removing effect, the substrate can be uniformly processed. In addition, the time necessary for the etching can be shortened.

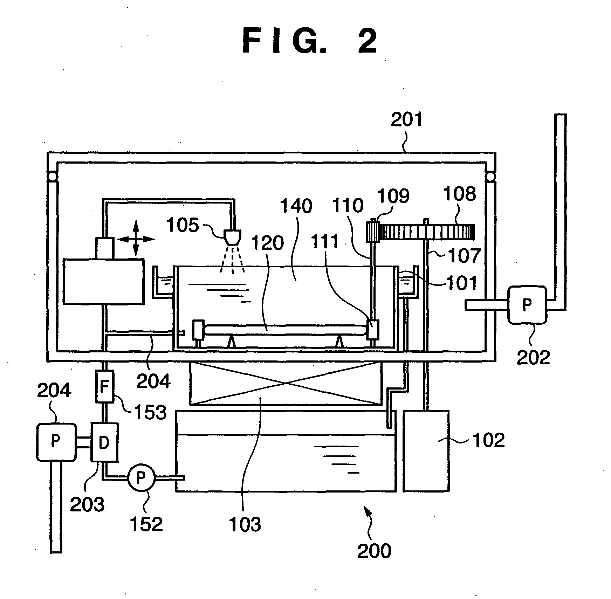

Fig. 2 is a view showing an improved example of the etching apparatus 100 shown in Fig. 1. The same reference numerals as in Fig. 1 denote the same constituent elements in Fig. 2. An etching apparatus 200 of the improved example has a chamber 201 which isolates at least the open portion (the portion where the etchant in the etching container 101 is exposed to the space) of the etching container 101, and typically, the entire etching container 101 from the external environment and exposes the etchant in the etching container 101 to a low-pressure environment (e.g., a vacuum environment). In the example shown in Fig. 2, the etching container 101 is wholly arranged in the chamber 201. The gas in the chamber 201 is exhausted by a pump 202. Accordingly, a low-pressure environment is formed.

When the etchant in the etching container 101 is exposed to the low-pressure environment, reaction bubbles that exist in the pores in the porous layer of the substrate 120 can efficiently be removed from the pores. Such a reaction bubble removing effect has been confirmed by experiments.

When the etchant in the etching container 101 is exposed to the low-pressure environment, the removal of reaction bubbles in the pores is estimated to be promoted by the following mechanism. When the etchant is exposed to the low-pressure environment, the dissolved gas in the etchant is diffused to the low-pressure environment. This decreases the dissolved gas concentration in the etchant. As a consequence, the reaction gas in the pores readily dissolves in the etchant, and reaction bubbles are quickly removed from the pores.

The etching apparatus 200 also preferably has, in the etchant circulation line, a deaerator 203 that removes the dissolved gas from the etchant. The pressure in the deaerator (e.g., a hollow fiber unit) 203 is decreased by a pump 204. When the dissolved gas in the etchant is removed by the deaerator 203, the reaction gas in the pores readily dissolves in the etchant, and reaction bubbles are quickly removed from the pores.

The etching apparatus preferably has both the above-described chamber 201 and deaerator 203.
However, one of them also suffices.

### [Examples]

### (Example 1)

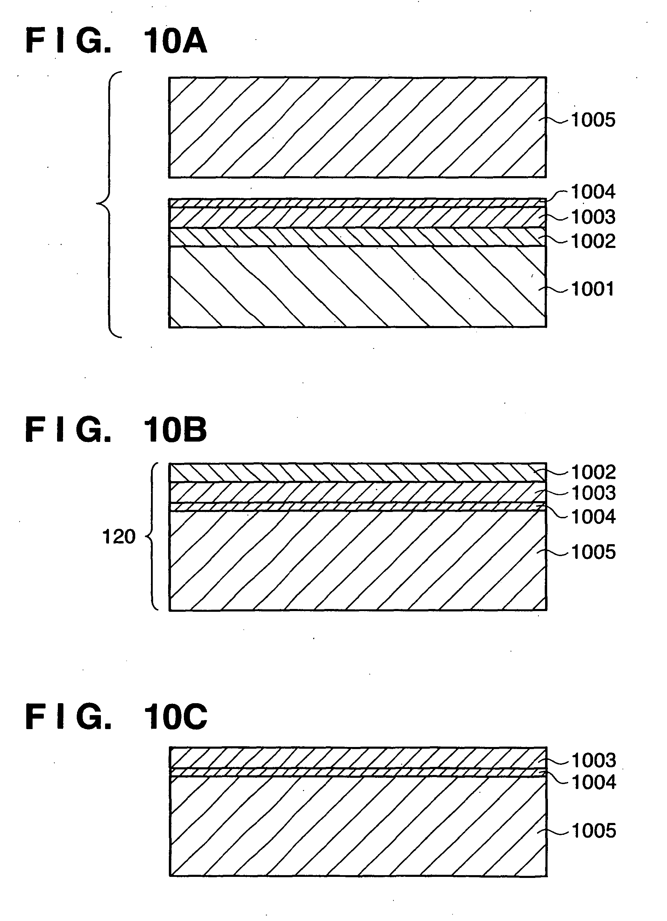

An example in which the porous layer etching apparatus 100 or 200 according to the preferred embodiment of the present invention is applied to the SOI substrate manufacturing step will be described with reference to Figs. 10A to 10C, 12, and 1.

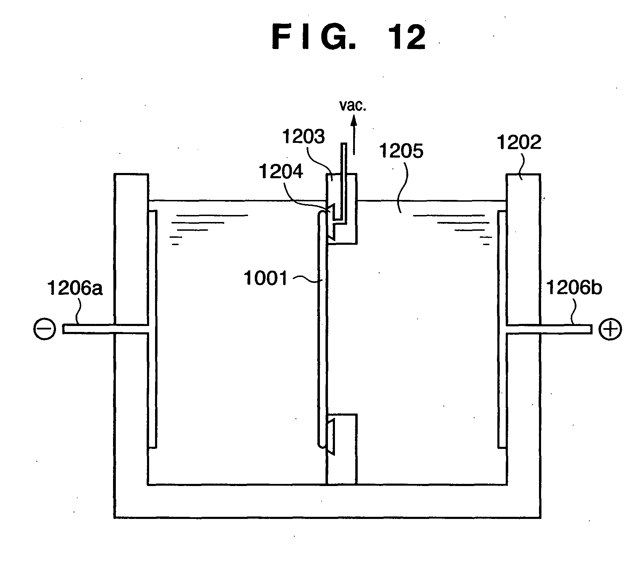

Fig. 12 is a view showing an example of an anodizing apparatus used to form porous silicon. First, a silicon substrate 1001 is anodized using the anodizing apparatus shown in Fig. 12 to form a porous layer on the surface of the substrate. More specifically, the substrate 1001 is set in a holder 1203 arranged in an anodizing container 1202. The holder 1203 has an annular chucking pad 1204 and an opening portion at the internal portion. The periphery of the lower surface of the silicon substrate 1001 is chucked and held by the chucking pad 1204. In this state, the anodizing container 1202 is filled to a predetermined level with an anodizing solution 1205. A DC current is applied between electrodes 1206a and 1206b made of platinum and attached to the two ends of the anodizing container 1202. With this process, the surface layer (the side facing the negative electrode 1206a) of the substrate 1001 can be porosified.

Figs. 10A to 10C are views for explaining steps in manufacturing an SOI substrate.

In the step shown in Fig. 10A, a 12-inch p-type silicon substrate 1001 having a resistivity of 15 [mΩ cm] was prepared. A porous silicon layer 1002 having a thickness of 10 µm was formed on the surface layer of the substrate 1001 by using the anodizing apparatus shown in Fig. 12. The composition of the anodizing solution was HF : ethanol = 2 : 1. A fixed current having a current value of 17 mA/cm² was supplied for 10 min.

Subsequently, a non-porous epitaxial silicon layer 1003 having a thickness distribution of 150 ± 2 nm was formed on the surface of the substrate by CVD. The surface of the epitaxial silicon layer 1003 was oxidized to form a 100-nm thick silicon oxide film layer 1004. Another 12-inch substrate 1005 was prepared. The two substrates were cleaned, and their surfaces were bonded to prepare a bonded substrate stack.

In the step shown in Fig. 10B which illustrates the final state, the bonded substrate stack was annealed in a nitrogen atmosphere at 1,100°C for 2 hrs to increase the bonding strength. The substrate portion 1001 was removed by grinding the bonded substrate stack from the side of the p-type silicon substrate 1001 by using a grinder to expose the porous silicon layer 1002 (the state shown in Fig. 10B). Instead of grinding, a separation method may be employed to separate the bonded substrate stack at the portion of the porous layer 1004 into two parts. As the separation method, various methods can en employed. Of all the methods, a method using a fluid, particularly, a method of injecting a fluid to the porous layer can preferably be used.

The substrate (intermediate substrate) 120 shown in Fig. 10B was set in the etching apparatus 100 shown in Fig. 1 to selectively etch the porous silicon layer 1002. As the etchant, a solution mixture containing HF, H₂O₂, and H₂O was used. The mixture ratio of the solution mixture was HF : H₂O₂ : H₂O = 0.5% : 19.5% : 80%. The selective etching was executed while the substrate 120 was rotated at 20 rpm by the motor 102.

In this example, the etchant was not supplied from the supply portion (discharge portion) 105 on the upper side. The etchant was introduced from only the supply portion 104 on the lower side into the etching container 101. The porous layer was etched by using an overflow circulation method. The ultrasonic oscillator 103 continuously oscillated a 900-kHz ultrasonic wave. With this selective etching, the porous silicon layer 1002 having a thickness of about 10 µm was completely removed in 70 min. As a result, a substrate having an SOI structure (SOI substrate) shown in Fig. 10C was obtained. Referring to Fig. 10C, the epitaxial silicon layer 1003 had a film thickness distribution of 90 ± 2 nm. As is apparent from this result, when the etching apparatus shown in Fig. 1 is used, the film thickness distribution of the epitaxial silicon layer 1003 rarely deteriorates.

### (Example 2)

A substrate (intermediate substrate) 120 having a porous layer 1002 exposed to the surface, as shown in Fig. 10B, was prepared in accordance with the same procedures as in Example 1.

The porous silicon layer 1002 of the substrate 120 was selectively etched by using the etching apparatus 200 shown in Fig. 2. The etching apparatus 200 shown in Fig. 2 has the chamber 201 and vacuum pump 202, which can set a low-pressure environment in the etching container 101, in addition to the etching apparatus 100 shown in Fig. 1. The etching apparatus 200 also has, in the etchant circulation line, the deaerator (hollow fiber unit) 203 which removes the dissolved gas in the solution and the vacuum pump 204.

As conditions in etching the porous layer, the composition of the etchant, the rotational speed of the substrate, and the conditions of the ultrasonic wave supplied from the bottom of the etching container were the same as in Example 1. In Example 2, etchant supply from the supply portion (discharge portion) 105 was also simultaneously executed. The supply portion 105 incorporated an ultrasonic oscillator. By using the ultrasonic oscillator, a 1.5-MHz megasonic wave was applied to the etchant supplied from the supply portion 105. In addition, the supply portion 105 was reciprocally moved at 1 Hz on radials from the center to the periphery of the substrate 120. The pressure in the chamber 201 was decreased to 80 Pa, and the dissolved oxygen and nitrogen in the etchant were removed. As a result, the porous silicon layer 1002 having a thickness of about 10 µm was completely removed in 50 min. A substrate having an SOI structure shown in Fig. 10C was obtained.

After the selective etching, the epitaxial silicon layer 1003 had a film thickness distribution of 90 ± 2 nm. That is, when the etchant applied with the megasonic wave was supplied from the upper side, the internal pressure of the etching container 101 was wholly reduced, and the dissolved gas in the etchant was removed, the etching time could be shortened by about 30% without degrading the etching selectivity.

### (Example 3)

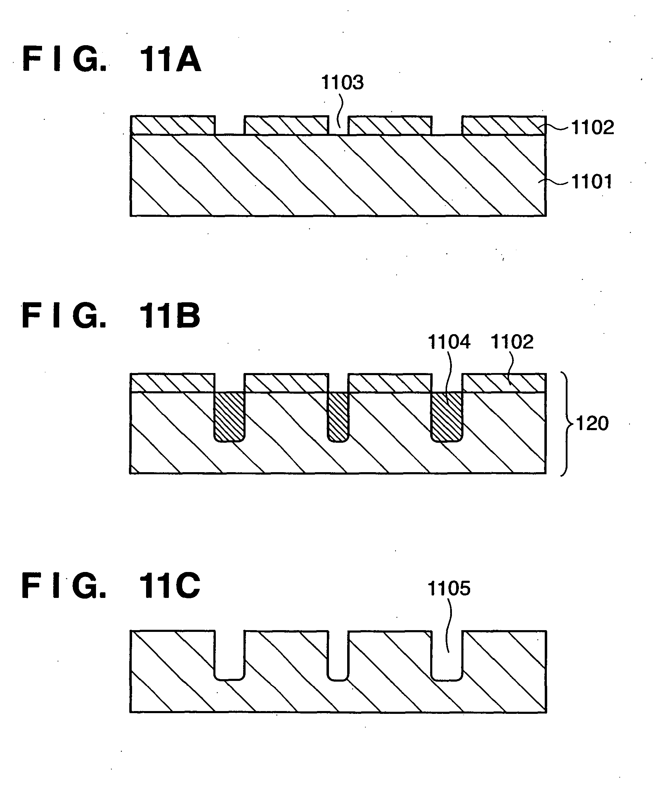

Example 3 will be described with reference to Figs. 11A to 11C, 3A, and 3B.

First, an 8-inch p-type substrate 1101 having a resistivity of 15 [mΩcm] shown in Fig. 11A was prepared. A silicon nitride film 1102 having a thickness of 500 nm was deposited on the substrate 1101 by plasma CVD. Opening portions 1103 were formed by a photo process using a resist. The substrate in this state was anodized by using the anodizing apparatus shown in Fig. 12 under the same conditions as in Example 1. As a result, porous silicon portions 1104 were formed to a depth of 15 µm at only the parts of the opening portions 1103 by using the silicon nitride film as a mask, as shown in Fig. 11B.

While keeping the silicon nitride film 1102 remaining, the substrate 120 was set in the etching apparatus 100 shown in Fig. 1 to etch the porous silicon portions 1104. At this time, the substrate rotating mechanism 130 shown in Fig. 1 was detached. Instead, the substrate holders shown in Figs. 3A and 3B were attached. More specifically, the substrate holders shown in Figs. 3A and 3B were installed in the etching apparatus 100 shown in Fig. 1, and the substrate was set in the substrate holders. In this state, the etchant was injected from the supply portion 304 to the container at a flow rate of 5 l/min. The substrate 301 rotated on its own axis due to the generated flow of the fluid. As etching conditions, the etchant composition and the ultrasonic wave from the bottom of the container had the same conditions as in Example 1. For etchant supply from the supply portion 105 on the upper side, the same conditions as in Example 2 were set.

As a result, the porous silicon portions 1104 were completely removed in 60 min. After that, the silicon nitride film 1102 remaining as a mask was removed. A trench structure having a depth of 15 µm was formed, as shown in Fig. 11C.

According to the present invention, even when the substrate size increases, the substrate can uniformly be processed. When the present invention is applied to selective etching, even when the substrate size increases, the etching selectivity does not deteriorate, and a satisfactory etching distribution can be obtained.

As many apparently widely different embodiments of the present invention can be made without departing from the spirit and scope thereof, it is to be understood that the invention is not limited to the specific embodiments thereof except as defined in the claims.

Even when the substrate size increases, the substrate is processed (etched) uniformly. An ultrasonic oscillator (103) is arranged under an etching container (101). A substrate (120) is horizontally arranged in the etching container (101). Accordingly, the substrate (120) is arranged while making a surface face the ultrasonic oscillator (103). The substrate (120) is etched while being rotated by a rotating mechanism (130).

## Claims

1. A processing apparatus which processes a substrate by a process solution, comprising:
a process container which stores the process solution;
a holding mechanism which holds the substrate in said process container;
an oscillation source which is arranged at a predetermined position in a direction perpendicular to a surface of the substrate held by said holding mechanism to supply an oscillation to the substrate; and
a structure configured to rotate the substrate held by said holding mechanism.

2. The apparatus according to claim 1, wherein said structure is configured to transmit a rotating force to the substrate by a solid member.

3. The apparatus according to claim 2, wherein said structure is configured to rotate the substrate by rotating said holding mechanism.

4. The apparatus according to claim 1, wherein said structure is configured to rotate the substrate by forming a flow of the process solution.

5. The apparatus according to claim 4, wherein said structure is configured to rotate the substrate by forming one of a rotational flow and a vortex flow of the process solution in said process container.

6. The apparatus according to claim 1, wherein said structure has a supply portion which supplies the process solution into said process container to form a flow of the process solution in said process container and is configured to rotate the substrate by the flow of the process solution.

7. The apparatus according to claim 1, further comprising a discharge portion which discharges the process solution to the surface of the substrate to remove bubbles that can be generated in processing the substrate.

8. The apparatus according to claim 7, wherein said discharge portion is configured to discharge the process solution to a local region in the surface of the substrate.

9. The apparatus according to claim 7, further comprising a driving mechanism which moves said discharge portion during processing of the substrate.

10. The apparatus according to claim 9, wherein said driving mechanism is configured to be able to reciprocally move said discharge portion to sequentially inject the process solution discharged from said discharge portion to an entire surface of the substrate.

11. The apparatus according to claim 1, further comprising a mechanism which deaerates the process solution.

12. The apparatus according to claim 1, further comprising a chamber to form a low-pressure environment in a space including at least a portion where the process solution in said process container is exposed.

13. The apparatus according to claim 1, further comprising a chamber to accommodate said process container and form a low-pressure environment around said process container.

14. A processing apparatus which processes a substrate by a process solution, comprising:
a process container which stores the process solution; and
a structure which rotates the substrate by forming a flow of the process solution in said process container.

15. A processing apparatus which processes a substrate by a process solution, comprising:
a process container which stores the process solution; and
a discharge portion which discharges the process solution to a surface of the substrate in said process container to remove bubbles that can be generated in processing the substrate.

16. A processing apparatus which processes a substrate by a process solution, comprising:
a process container which stores the process solution; and
a chamber to form a low-pressure environment in a space including at least a portion where the process solution in said process container is exposed.

17. A processing method of processing a substrate by a process solution, comprising:
an arrangement step of arranging the substrate in a process container which stores the process solution; and
a process step of processing the substrate by the process solution while rotating the substrate,
wherein in the arrangement step, the substrate is arranged while making a surface of the substrate face an oscillation source which supplies an oscillation to the substrate, and in the process step, the oscillation source is operated to supply the oscillation to the substrate.

18. The method according to claim 17, wherein in the process step, the substrate is rotated by transmitting a rotating force to the substrate by using a solid member.

19. The method according to claim 17, wherein in the process step, the substrate is rotated by forming a flow of the process solution.

20. The method according to claim 19, wherein the substrate is rotated by forming one of a rotational flow and a vortex flow of the process solution in the process container.

21. The method according to claim 17, wherein in the process step, the process solution is discharged to the surface of the substrate to remove bubbles that can be generated in processing the substrate.

22. The method according to claim 21, wherein in the process step, the process solution is discharged to a local region in the surface of the substrate.

23. The method according to claim 22, wherein in the process step, the substrate is processed while changing the region of the substrate to which the process solution should locally be supplied.

24. The method according to claim 23, wherein in the process step, the process solution is sequentially injected to an entire surface of the substrate while changing the region of the substrate to which the process solution should locally be supplied.

25. The method according to claim 17, wherein at least in the process step, the process solution is deaerated.

26. The method according to claim 17, wherein the process step is executed while forming a low-pressure environment in a space including a portion where the process solution in the process container is exposed.

27. A processing method of processing a substrate by a process solution, comprising:
an arrangement step of arranging the substrate in a process container which stores the process solution; and
a process step of processing the substrate by the process solution while rotating the substrate,
wherein in the process step, the substrate is rotated by forming a flow of the process solution.

28. A processing method of processing a substrate by a process solution, comprising:
an arrangement step of arranging the substrate in a process container which stores the process solution; and
a process step of processing the substrate by the process solution while rotating the substrate,
wherein in the process step, the process solution is discharged to the surface of the substrate to remove bubbles that can be generated in processing the substrate.

29. A processing method of processing a substrate by a process solution, comprising:
an arrangement step of arranging the substrate in a process container which stores the process solution; and
a process step of processing the substrate by the process solution while rotating the substrate,
wherein the process step is executed while forming a low-pressure environment in a space including a portion where the process solution in the process container is exposed.

30. The method of any one of claims 17 and 27 to 29,
wherein the process step includes a step of etching the substrate.

31. The method according to claim 30, wherein the substrate has a porous region and a non-porous region, and in the etching step, the porous region of the substrate is selectively etched.

32. A method of manufacturing a semiconductor substrate, comprising steps of:
bonding a second substrate to a side of a non-porous semiconductor layer of a first substrate to prepare a bonded substrate stack, the first substrate having the non-porous semiconductor substrate on a porous layer;
processing or fabricating the bonded substrate stack to prepare an intermediate substrate in which the non-porous semiconductor layer is present on the second substrate, and the porous layer at least partially remains on the non-porous semiconductor layer; and
selectively etching the remaining porous layer in the intermediate substrate by an etching step defined in claim 30.
